# EUROPEAN PATENT APPLICATION

(11) **EP 1 160 845 A2**
(43) Date of publication of application: **05.12.2001**
(21) Application number: 01112273.6
(22) Date of filing: 18.05.2001
(51) Int. Cl.: H01L 21/265, H01L 21/329, H01L 21/336, H01L 21/324

(54) **Method for fabricating a silicon carbide semiconductor device**

(30) Priority: 23.05.2000 JP 2000151243
(71) Applicant: MATSUSHITA ELECTRIC INDUSTRIAL CO., LTD., Kadoma-shi, Osaka 571-8501 (JP)
(72) Inventor: Takahashi, Kunimasa, Ibaraki-shi, Osaka 567-0845 (JP); Kitabatake, Makoto, Nara-shi, Nara 631-0076 (JP); Uchida, Masao, Ibaraki-shi, Osaka 567-0823 (JP); Yokogawa, Toshiya, Nara-shi, Nara 630-8101 (JP); Kusumoto, Osamu, Nara-shi, Nara 631-0003 (JP)
(74) Representative: Grünecker, Kinkeldey, Stockmair & Schwanhäusser Anwaltssozietät

(57) **Abstract**

A method for fabricating a semiconductor device that includes a semiconductor layer, containing Si and C, for its active region. Ions of a dopant are implanted into an SiC substrate a number of times, thereby forming a doped layer with multiple dopant concentration peaks in the substrate. Thereafter, the substrate is placed and annealed in a chamber with an etching gas (e.g., hydrogen gas) supplied thereto. In this manner, while the substrate is being annealed, the upper part of the doped layer is removed with the lower part thereof left. Accordingly, the dopant concentration at the surface of the lower doped layer can be easily controlled to such a value as required for forming a Schottky or ohmic electrode thereon. In addition, the upper doped layer with a lot of defects is removed, and therefore the surface region of the substrate can have its crystallinity improved.

## Description

### BACKGROUND OF THE INVENTION

The present invention relates to a semiconductor device fabrication process that includes the process step of implanting dopant ions into a semiconductor layer containing Si and C, e.g., an SiC or SiGeC layer.

Silicon carbide (SiC) is a semiconductor that has a wider bandgap than that of silicon (Si). Accordingly, SiC has a higher breakdown field and a higher melting point compared to Si. In view of these beneficial properties, SiC is a semiconductor material hopefully applicable to next-generation power electronic devices, RF devices, high-temperature-operating devices and so on. It is also known that Sic can take various crystal structures including cubic ones such as 3C-SiC and hexagonal ones like 6H-SiC and 4H-SiC.

Normally, an SiC device is formed by defining some required regions in an SiC substrate. When a diode should be formed, for example, p-, i- (intrinsic) and n-type regions need to be defined in an SiC substrate. In forming an FET on the other hand, source/drain and channel regions should be defined therein. In this case, any particular region of the SiC substrate can have a desired conductivity type by implanting ions of a dopant into the substrate. More specifically, where an n-type region should be defined, ions of an n-type dopant, like nitrogen (N), phosphorus (P), etc., may be implanted into the substrate. A p-type region may be defined by implanting ions of a p-type dopant, e.g., boron (B), aluminum (Al), etc., into the substrate. Where this widespread ion implantation technique is adopted, the SiC substrate, into which the dopant ions have been implanted, is placed in an annealing furnace and then heated to an elevated temperature of 1300°C or more with argon gas supplied into the furnace at the atmospheric pressure. In this manner, the ion-implanted regions in the SiC substrate can have their crystallinity recovered (or their damage repaired) and the dopant atoms introduced can be activated at a time.

The known ion implantation process, however, has the following drawbacks.

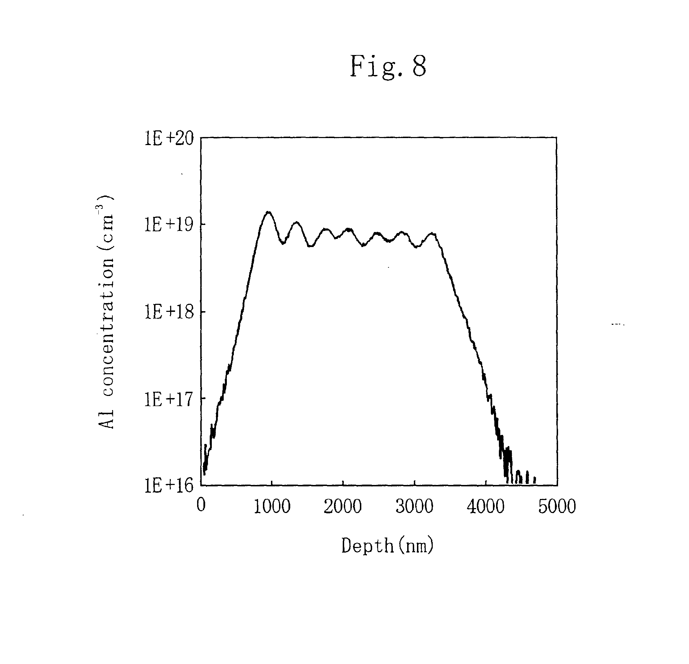

FIG. **8** illustrates a vertical dopant (Al in this case) concentration profile in an SiC substrate that has been subjected to the known ion implantation process. As shown in FIG. **8**, the ions, which have been implanted into the SiC substrate, have hardly diffused even after the substrate has been annealed at 1300°C or more. Accordingly, even after the substrate has been annealed, the profile of the dopant, introduced into the substrate by performing the ion implantation process only once, still shows a Gaussian distribution just like before the dopant introduced is annealed. For that reason, the ion implantation process is normally performed several times with the implant energy changed each time, thereby trying to define a doped region with as uniform a concentration as possible and with a predetermined width. However, as can be seen from FIG. **8**, the dopant concentration is unexpectedly low in the upper part of the SiC substrate over the uppermost dopant concentration peak located at a depth of about 1000 nm. That is to say, a region with a non-controllable dopant concentration exists in that part of the SiC substrate over the depth of about 1000 nm. Thus, according to the known technique, it is difficult to control the dopant concentration in that surface region of the SiC substrate to a desired value. In such a situation, even if an ohmic or Schottky electrode is formed on the SiC substrate, expected ohmic or Schottky characteristics are not realizable. In addition, that surface region of the SiC substrate should have been damaged seriously (i.e., have non-negligible crystal imperfections), because the dopant ions have passed that region the same number of times the ion implantation process has been performed thereon. For example, a known Schottky diode cannot have a sufficiently high breakdown voltage, which fact shows that the damage, caused by these multiple high-energy ion implantation processes, cannot be completely repaired even after the substrate has been annealed.

Theoretically speaking, it is not impossible to minimize the thickness of the upper part of the SiC substrate over the uppermost dopant concentration peak if the process step of implanting dopant ions at a relatively low implant energy is additionally performed. In that case, however, a high-energy ion implantation machine specially designed for implanting ions on the order of mega electron volts and a normal ion implantation machine designed for implanting ions at an energy of 1000 keV or less should be used in combination, which is far from being practical. Furthermore, even if those two types of machines could be used in combination, the upper part of the SiC substrate with the non-controllable dopant concentration is still subject to serious damage because that part must experience the multiple ion implantation processes. Accordingly, the crystallinity of the upper part should have deteriorated seriously.

Thus, to avoid these inconveniences, that upper part of the SiC substrate, which is a relatively thick region located over the uppermost peak of dopant concentration and has the unexpectedly low dopant concentration, may be removed. The current process technology for MOS transistors and so on to be formed on an Si substrate is applicable for this purpose in the following manner. Specifically, after the SiC substrate has been annealed, part of the substrate, usually hard to wet-etch away directly, can be removed either by performing a dry etching process using a plasma or by thermally oxidizing that part of the substrate and then wet-etching the oxide film away.

However, if that part should be dry-etched away, it is difficult to control the depth of the part removed accurately. Thus, the resultant depth might change greatly among the respective lots. In addition, to break the strong bond of SiC, the plasma to be produced should have a rather high energy. Accordingly, when the surface of the SiC substrate is exposed to such high-energy radiation, defects might be newly created in the upper part of the SiC substrate again. Thus, it is expected that even if the substrate is annealed again after that, it will be still difficult to recover the crystallinity sufficiently. On the other hand, according to the latter thermal oxide forming/removing technique, it takes a great deal of time and trouble. This is because the thickness of an oxide film that can be formed by a single thermal oxidation process is at most about 100 nm, due to the low oxidation rate, and the thermal oxidation and wet etching should be performed as many as ten times just to remove that part.

Similar problems also arise when a dopant is introduced into an Si_{1-x-y}GeₓC_{y} or Si_{1-y}C_{y} (where 0<x<1 and 0 < y < 1) layer in a heterojunction bipolar transistor, which has been formed on an Si substrate, to define an active region for the transistor therein. The Si_{1-x-y}GeₓC_{y} or Si_{1-y}C_{y} layer contains C at just a low mole fraction. Even so, the annealing can hardly change the as-implanted dopant concentration profile because the C atoms prevent the dopant atoms from diffusing.

### SUMMARY OF THE INVENTION

It is therefore an object of the present invention to get a semiconductor device, including, e.g., an SiC or Si₁₋ₓ₋ _{y}GeₓC_{y} layer, fabricated much more easily by making the upper part of the layer removable accurately without doing any additional damage on the remaining part of the layer.

An inventive method is applicable to fabricating a semiconductor device on a substrate, which includes a semiconductor layer containing at least silicon and carbon, so that an active region of the device is defined in the semiconductor layer. The method includes the step of a) implanting ions of a dopant into the semiconductor layer. The method further includes the step of b) placing the substrate in a chamber and removing part of the semiconductor layer to a predetermined depth with the substrate heated at least to a temperature at which the dopant is activated. The depth is measured from the surface of the semiconductor layer. And the step b) is performed after the step a) has been performed.

In general, if a semiconductor layer contains carbon, the profile of a dopant, which has been introduced into the layer through ion implantation, hardly changes even after the substrate has been subjected to an annealing process to activate the dopant. Even so, according to the present invention, any peak of the dopant concentration in the surface region of the semiconductor layer can be located at the surface by removing the part over the peak. In addition, the surface region, which has been damaged particularly seriously through the ion implantation processes, can be removed. Accordingly, when an electrode that makes a Schottky or ohmic contact with the semiconductor layer should be formed on the layer, desired characteristics are easily realizable.

In one embodiment of the present invention, that part of the semiconductor layer may be removed in the step b) so that the dopant has a predetermined concentration at the surface of the other remaining part of the semiconductor layer. Then, a Schottky or ohmic electrode with desired characteristics can be formed accurately.

In another embodiment, an etching gas, which has a property of etching the semiconductor layer, may be introduced into the chamber in the step b) to etch away said part of the semiconductor layer. In this manner, the surface part of the semiconductor layer is removable without doing any additional damage on the remaining part of the semiconductor layer.

In still another embodiment, the semiconductor layer may be made of silicon carbide. In the step b), that part of the semiconductor layer may be etched away using a gas that contains at least one element selected from the group consisting of hydrogen and the halogen elements.

Specifically, the substrate is preferably heated in the step b) to a temperature between 1300°C and 2300°C. Then, the implant-induced damage in the semiconductor layer can be repaired while the upper part thereof is being removed.

Also, the etching gas is preferably supplied in the step b) at a flow rate between 0.001 l/min and 10 l/min.

### BRIEF DESCRIPTION OF THE DRAWINGS

FIGS. **1A** through **1C** illustrate basic process steps for forming an SiC layer for a semiconductor device in accordance with the present invention.
FIG. **2** is a cross-sectional view illustrating a structure for an annealing furnace for use in the present invention.
FIG. **3** is a graph illustrating a dopant profile in an SiC substrate, which was subjected to the concurrent anneal-etch process according to a first embodiment of the present invention, as a result of secondary ion mass spectrometry (SIMS).
FIG. **4** is a graph illustrating, based on experimental data, how the etch rate of an SiC substrate changes with the temperature of the substrate.
FIG. **5** is a graph illustrating, based on experimental data, how the etch rate of an SiC substrate changes with the flow rate of hydrogen gas.
FIGS. **6A** through **6C** are cross-sectional views illustrating respective process steps for forming a Schottky diode according to a second embodiment of the present invention.
FIGS. **7A** through **7C** are cross-sectional views illustrating respective process steps for forming a MISFET according to a third embodiment of the present invention.
FIG. **8** is a graph illustrating a vertical Al concentration profile in an SiC substrate prepared by a known method.

### DESCRIPTION OF THE PREFERRED EMBODIMENTS

### EMBODIMENT 1

Hereinafter, a first embodiment of the present invention will be described. The first embodiment represents the basic idea of the inventive concurrent anneal-etch process.

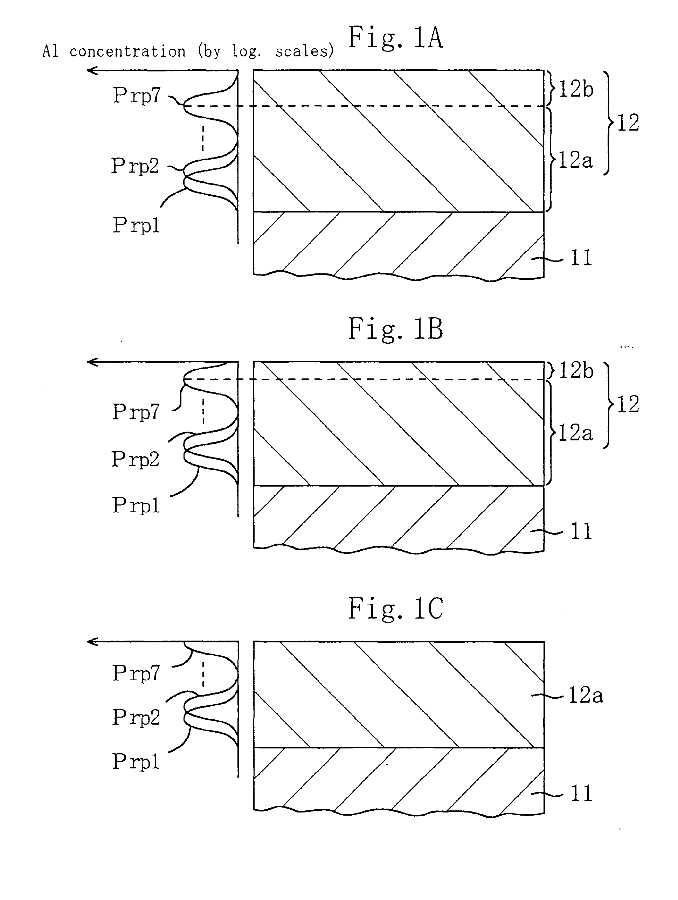

FIGS. **1A** through **1C** illustrate fundamental process steps for forming an SiC layer for a semiconductor device in accordance with the present invention.

First, in the process step shown in FIG. **1A,** an SiC substrate **11** is prepared. The substrate **11** may be a 6H-SiC substrate with a (0001) off-axis plane as its principal surface. That is to say, the principal surface of the SiC substrate **11** may tilt from a (0001) crystallographic plane (i.e., a C-plane) in the [11-20] direction by 3.5 degrees. Also, the surface of the 6H-SiC substrate **11** may be an n-type Si face in which Si atoms are closely packed. The SiC substrate **11** may have a diameter of be about 25 mm, for example.

Then, Al ions (Al⁺) are implanted into the SiC substrate **11** through ion implantation processes that are performed seven times, for example, at mutually different implant energies. As a result, a p-type doped layer **12,** into which Al atoms have been introduced, is formed in the SiC substrate **11.** In this layer **12,** seven peaks **Prp1, Prp2,** ... and **Prp7** of Al concentrations, corresponding to the respective implant energy values, exist. In this case, part of the doped layer **12,** located under the uppermost peak **Prp7,** may be a lower doped layer **12a,** while the other part thereof located over the uppermost peak **Prp7** may be an upper doped layer **12b.**

However, the boundary between the upper and lower doped layers **12b** and **12a** does not have to correspond to the uppermost peak **Prp7.** So in this and following embodiments, the upper doped layer **12b** shall mean part of the doped layer **12** to be etched away, while the lower doped layer **12a** the other part thereof to be left.

The ion implantation processes are performed under the following conditions. Specifically, the first ion implantation process, corresponding to the peak **Prp1,** is performed at an accelerating voltage of 7.0 MeV and at a dose of 3×10¹⁴ atoms · cm⁻². The second ion implantation process, corresponding to the peak **Prp2,** is performed at an accelerating voltage of 5.6 MeV and at a dose of 3×10¹⁴ atoms · cm⁻². The third ion implantation process, corresponding to the peak **Prp3,** is performed at an accelerating voltage of 4.4 MeV and at a dose of 7×10¹⁴ atoms · cm⁻². The fourth ion implantation process, corresponding to the peak **Prp4,** is performed at an accelerating voltage of 3.3 MeV and at a dose of 7 × 10¹⁴ atoms · cm⁻². The fifth ion implantation process, corresponding to the peak **Prp5,** is performed at an accelerating voltage of 2.4 MeV and at a dose of 3 × 10¹⁴ atoms · cm⁻². The sixth ion implantation process, corresponding to the peak **Prp6,** is performed at an accelerating voltage of 1.6 MeV and at a dose of 3 × 10¹⁴ atoms · cm⁻². And the seventh ion implantation process, corresponding to the peak **Prp7,** is performed at an accelerating voltage of 1.0 MeV and at a dose of 3 × 10¹⁴ atoms · cm⁻². The direction in which the Al ions are implanted may form an angle of seven degrees with a normal to the surface of the SiC substrate **11.** These ion implantation processes are always performed at room temperature. The Al concentration profile in the doped layer formed by these ion implantation processes was measured using a secondary ion mass spectrometer (SIMS). Consequently, the same result shown in FIG. **8** was obtained. Specifically, the doped layer **12** had an average dopant concentration of about 5 × 10¹⁸ atoms · cm⁻³ and a thickness of about 4 µm. More specifically, the lower doped layer **12a** had a thickness of about 3 µm and the upper doped layer **12b** had a thickness of about 1µm.

Next, in the process step shown in FIG. **1B,** annealing and etching processes are performed in parallel. That is to say, the substrate is placed in an annealing furnace and then heated to a temperature somewhere between 1300°C and 2300°C within a hydrogen ambient. As a result, the upper doped layer **12a** is removed little by little downward from its surface, or decreases its thickness gradually. More specifically, this process step is carried out in the following manner.

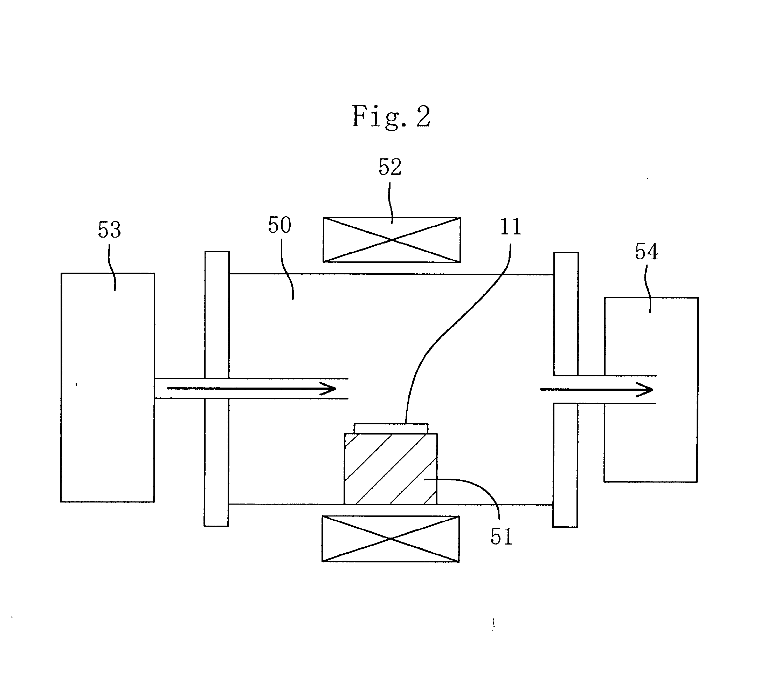

FIG. **2** is a cross-sectional view illustrating a structure for an annealing furnace for use in the present invention. As shown in FIG. **2,** the furnace includes chamber **50,** substrate holder **51,** induction heating coil **52,** gas supply system **53** and gas exhaust system **54.** The chamber **50** may be made of quartz, while the holder **51 may** be made of carbon, for example. The holder **51** is disposed inside the chamber **50** to place the SiC substrate **11** thereon. The coil **52** should heat the holder **51** and substrate **11** with radio frequency power. First, the pressure inside the chamber **50** is reduced to a vacuum under 10⁻⁶ Pa. Then, an annealing ambient gas is supplied from the gas supply system **53** into the chamber **50.** Where hydrogen gas is selected as a gas supplied for etching the surface part of the SiC substrate **11** during this annealing process, the flow rate of the hydrogen gas is set to 2 l/min, the pressure inside the chamber **50** during the annealing is fixed at the atmospheric pressure, and a power of 20 kW is applied to the coil **52** at a frequency of 20.0 kHz, thereby heating the SiC substrate **11** to 1600°C. At this temperature, the surface part of the SiC substrate **11** is etched away at a rate of 2 µm/hr within the hydrogen ambient. In the illustrated embodiment, the concurrent anneal-etch process is performed for 30 minutes, thereby removing the upper doped layer **12b** with the thickness of 1 *µ*m. Although I couldn't understand the mechanism of this reaction clearly enough, I believe that the hydrogen atoms or molecules should break the strong Si-C bonds to produce volatile substances like SiH₄ and CH₄. In the illustrated embodiment, no plasma is produced and this etching process would proceed almost purely chemically. However, some physical force placed would be negligible unless the SiC substrate is damaged seriously.

FIG. **1C** is a cross-sectional view illustrating a structure of the SiC substrate **11** when the concurrent anneal-etch process is finished. As shown in FIG. **1C,** the upper doped layer **12b** has been etched away completely and the uppermost peak **Prp7** is located almost at the surface of the SiC substrate **11.**

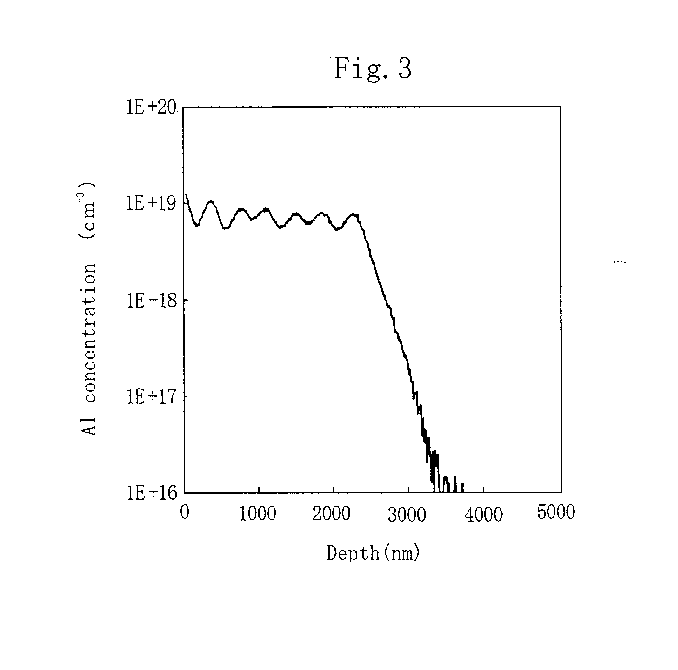

FIG. **3** is a graph illustrating the dopant concentration profile in the SiC substrate **11,** which was subjected to the concurrent anneal-etch process of the first embodiment, as a result of secondary ion mass spectrometry (SIMS). As shown in FIG. **3,** the dopant (i.e., Al in the illustrated embodiment) concentration at the surface of the SiC substrate **11** is almost equal to the concentration at the uppermost peak **Prp7**. That is to say, it can be seen that the dopant concentration at the surface was controlled to a desired value.

As described above, according to this embodiment, after dopant ions (i.e., Al ions in this embodiment) to be carriers have been implanted into the SiC substrate **11**, the SiC substrate **11** is heated to and kept at an elevated temperature with hydrogen gas supplied into the chamber. In this manner, the annealing process can be performed to repair the implant-induced damage while the surface part of the SiC substrate **11** is being etched away. Then, unlike the known dry etching process, no additional damage is done on the remaining part of the SiC substrate **11** and yet the surface part of the SiC substrate **11** (i.e., the upper doped layer **12b**), which has been damaged most seriously through the ion implantation, can be removed. Accordingly, the damage that is too serious to repair even through annealing is hardly left. For that reason, if the doped layer of this embodiment is used as an active region for any of various types of devices, then the number of crystal imperfections existing in the surface region of the device can be much smaller and the device can exhibit far better electrical characteristics.

Particularly when a number of devices of dissimilar types should be integrated together on a single SiC substrate, the method of this embodiment is very effective. This is because it is usually hard to form a locally doped layer in situ only in a specified region of an SiC layer that is being grown epitaxially. However, the method of this embodiment makes it possible to form a doped layer at any place we like by implanting dopant ions into some part of an SiC substrate. Accordingly, not only discrete devices but also a group of devices to be integrated together on a single SiC substrate can be fabricated by this method.

Furthermore, the SiC substrate prepared by the method of this embodiment as shown in FIG. **1C** has almost the same degree of surface planarity as an SiC substrate that has been annealed by a known method using Ar gas. That is to say, even though the SiC substrate shown in FIG. **1C** has been subjected to the concurrent anneal-etch process, the surface planarity thereof has not been affected.

In the foregoing illustrative embodiment, the annealing and etching processes are supposed to be carried out in parallel. However, the present invention is not limited to this specific example, but should be construed to encompass an alternative embodiment in which the annealing process is performed first using Argon gas, for example, and then the etching process is carried out using hydrogen gas, for example. But it is nonetheless true that the present invention is applicable particularly effectively to the concurrent anneal-etch process, because the process efficiency and degree of damage repair improve significantly in that case.

Furthermore, the present invention also realizes arbitrary control over the dopant concentration at the surface of the SiC substrate. In the foregoing embodiment, part of the SiC substrate, which is located over the uppermost one of the several dopant concentration peaks formed by the multiple ion implantation processes, is supposed to be removed. However, the uppermost peak does not always have to be chosen. Rather, so long as the relationship between the ion implantation conditions and the dopant concentration profile formed in the substrate is known beforehand, the substrate may be etched away to any desired depth associated with any arbitrary dopant concentration peak.

Also, in the foregoing embodiment, hydrogen gas is used as an exemplary etching gas for removing the surface part of the SiC substrate. However, the hydrogen gas is not the only one available according to the present invention. Examples of other qualified gases include halogen gases like chlorine, fluorine and bromine gases and interhalogen gases such as ClF₃ gas. In any case, the effects of the foregoing embodiment are also attainable.

It should be noted that the doped layer **12** formed in the upper part of the SiC substrate **11** in the foregoing embodiment may be replaced with an SiC single crystal layer that has been grown epitaxially on the SiC substrate **11**. That is to say, where an SiC substrate is used, part of the SiC substrate itself may be used as a semiconductor layer to which the present invention is applied. Or an SiC layer that has been grown epitaxially on the SiC substrate may be the semiconductor layer of the present invention. Generally speaking, though, a semiconductor layer grown epitaxially shows crystallinity superior to that of a semiconductor layer formed by a doping process. Thus, the semiconductor layer should preferably be grown epitaxially to obtain a device with a high breakdown voltage and good radio frequency characteristics.

Furthermore, whether the annealing process is performed using the hydrogen gas as specified for the foregoing embodiment or using a mixture obtained by adding hydrogen or halogen gas to a rare gas of argon, for example, the intended damage repair and selective etching effects are also attainable.

Moreover, in the foregoing embodiment, the concurrent anneal-etch process is carried out with the hydrogen gas supplied at a constant flow rate. However, the present invention is still effective even if the flow rate of the hydrogen gas is changed during the annealing process.

Also, in the foregoing embodiment, a p-type doped layer is formed by implanting Al ions. When an n-type doped layer should be formed, ions of an n-type dopant such as nitrogen (N) or phosphorus (P) may be implanted into the SiC substrate instead. In forming another p-type doped layer, ions of another p-type dopant like boron (B), not aluminum (Al), may be implanted thereto. Even so, the same effects are attainable by performing the concurrent anneal-etch process of this embodiment.

Furthermore, in the foregoing embodiment, the ion implantation processes are performed seven times at mutually different accelerating voltages. However, even if a doped layer should be formed by performing the ion implantation process just once, the concurrent anneal-etch process of this embodiment is also effectively applicable to the dopant concentration control of, and the removal of seriously damaged part from, the substrate.

Moreover, in the foregoing embodiment, a hexagonal 6H-SiC substrate is used as a substrate to be processed. Alternatively, any other hexagonal SiC substrate or a cubic 3C-SiC substrate may also be used. It is also known that where an Si_{1-x-y}GeₓC_{y} or Si_{1-y}C_{y} (where 0<x<1, 0.001≦y<1) layer, formed on/in an Si substrate, is used as an active region, a dopant introduced into the Si_{1-x-y}GeₓC_{y} or Si_{1-y}C_{y} layer hardly diffuses even after the layer has been annealed. Accordingly, the method of this embodiment is also applicable to forming a device like this including a semiconductor layer that contains Si and C. In that case, the semiconductor layer containing Si and C may be either an integral part of the substrate or separately formed on a substrate of sapphire, quartz, etc.

Furthermore, in the foregoing embodiment, the surface part of the SiC substrate is removed by heating the substrate to an elevated temperature and supplying hydrogen gas thereto. However, the surface part of the SiC substrate is removable by any other technique. For example, the surface part is also removable as intended if the substrate being heated is exposed to plasma, light, radicals or electrons. In these cases, the surface part is removed by utilizing a physical action. Even so, if the SiC substrate is heated to a certain high temperature, the surface part of the substrate is removable without doing so much damage on the substrate.

### Conditions for anneal-etch process

Next, preferred conditions for the concurrent anneal-etch process, performed by supplying hydrogen gas and keeping the substrate at an elevated temperature, will be specified based on the results of experiments I carried out.

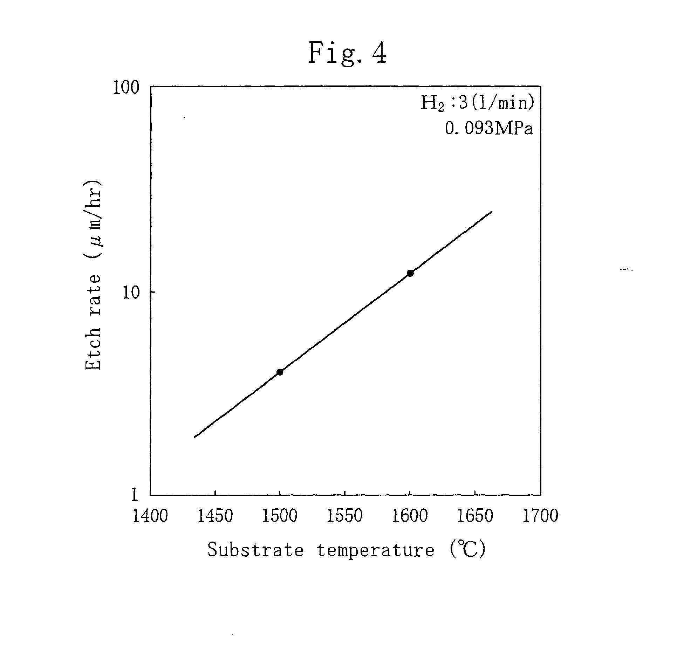

FIG. **4** is a graph illustrating, based on the experimental data I collected, how the etch rate of the SiC substrate changes with the temperature of the substrate. In FIG. **4**, the abscissa indicates the temperature (°C) of the SiC substrate, while the ordinate indicates the etch rate (µm/hr). The flow rate of hydrogen gas is set to 3 l/min. As can be seen from FIG. **4**, as the substrate temperature rises, the etch rate goes on increasing linearly. This is probably because the SiC etching reaction by hydrogen atoms or molecules is promoted by the temperature rise.

Particularly when the hydrogen gas is supplied as an etching gas into the annealing furnace (or chamber), the SiC substrate should preferably have a temperature between 500°C and 2300°C, both inclusive. The reason is as follows. On the one hand, if the substrate temperature is lower than 500°C, the hydrogen atoms cannot break the SiC bonds easily. On the other hand, if the substrate temperature exceeds 2300°C, then the SiC substrate itself might be decomposed unintentionally. Particularly in the concurrent anneal-etch process, the substrate temperature is preferably 1300°C or more. This is because I found that if the substrate temperature was less than 1300°C, the damage done on the SiC substrate could not be repaired sufficiently.

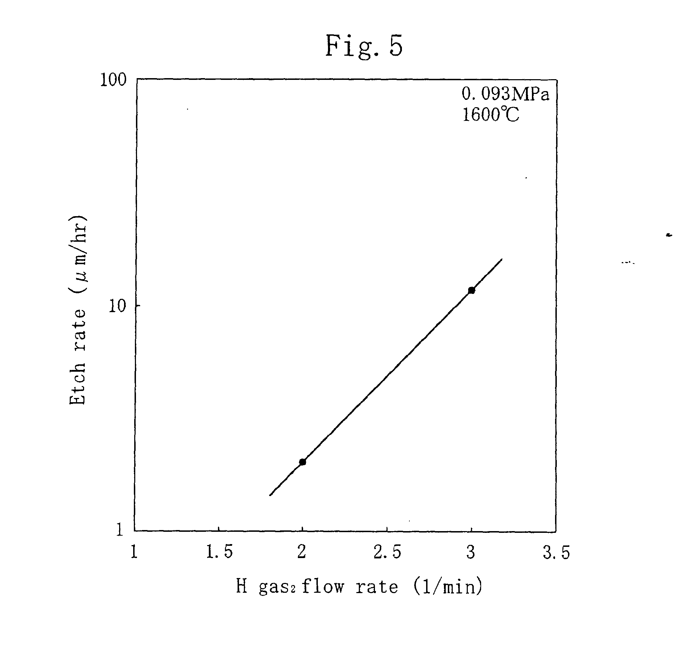

FIG. **5** is a graph illustrating, based on the experimental data I collected, how the etch rate of the SiC substrate changes with the flow rate of the hydrogen gas. In FIG. 5, the abscissa indicates the flow rate (l/min) of the hydrogen gas, while the ordinate indicates the etch rate (µm/hr). The temperature of the SiC substrate is fixed to at 1600 °C. As can be seen from FIG. **5**, the higher the flow rate of the hydrogen gas, the higher the etch rate. This is probably because as the flow rate of the hydrogen gas rises, the hydrogen atoms or molecules, contributing to the etching reaction of the SiC substrate, increase their numbers, or density. As can be seen from the results shown in FIGS. **4** and **5**, not just the substrate temperature but the flow rate of hydrogen gas can be used as convenient parameters for controlling the etch rate of the SiC substrate.

Where the SiC substrate is etched using hydrogen gas, the hydrogen gas preferably has a flow rate between 0.001 l/min and 10 l/min, both inclusive. This is because if the flow rate of the hydrogen gas is less than 0.001 l/min, then the etch rate will be too low to remove the desired surface part of the SiC substrate. However, if the flow rate of hydrogen gas exceeds 10 l/min, then the etch rate will be too high to control the thickness of that part removed from the SiC substrate accurately.

Also, in etching a semiconductor layer containing Si and C (which may be located either in or on the SiC substrate) using an etching gas like hydrogen gas, the etch rate is preferably 10 nm/min or more. Then, the surface part with the low dopant concentration can be accurately removed from the SiC substrate that has been subjected to the ion implantation processes at respective energies falling within a normal range of 1 keV to 10 MeV.

### EMBODIMENT 2

Next, a second embodiment of the present invention will be described. This embodiment relates to a method for forming a Schottky diode by utilizing the concurrent anneal-etch technique of the first embodiment.

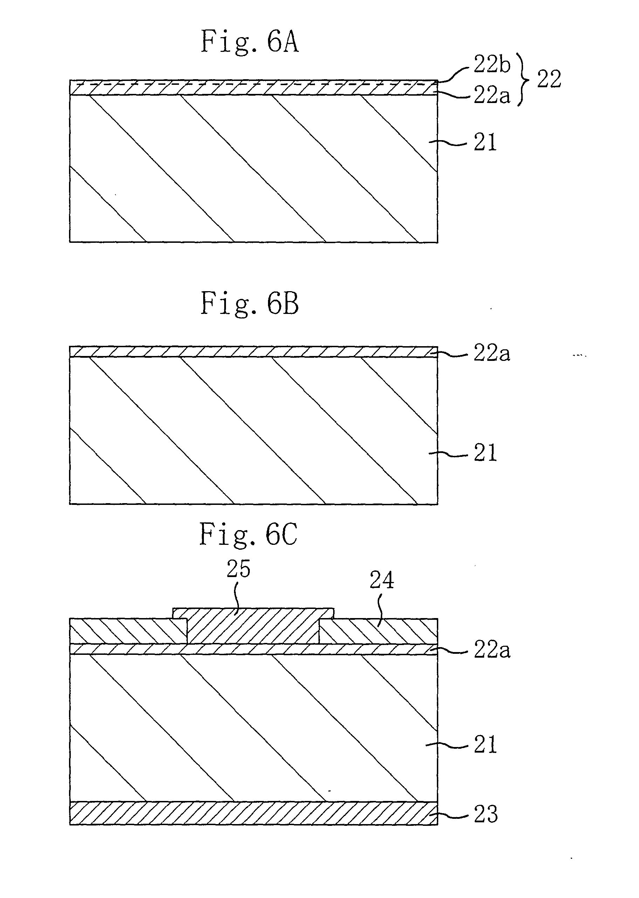

FIGS. **6A** through **6C** are cross-sectional views illustrating respective process steps for forming a Schottky diode according to the second embodiment.

First, in the process step shown in FIG. **6A,** an n⁺-type SiC substrate **21**, prepared by heavily doping a 6H-SiC substrate with nitrogen, is placed in the reaction chamber of a CVD apparatus and subjected to a CVD process. In the illustrated embodiment, the SiC substrate **21** has a (0001) off-axis plane as its principal surface. In this manner, an undoped SiC layer is epitaxially grown to a thickness of about 5*µ*m on the n⁺-type SiC substrate **21.** Thereafter, nitrogen (N) ions are implanted multiple times into the SiC layer by the method of the first embodiment, thereby forming an n-type doped layer **22**. In this case, the upper part of the doped layer **22** becomes an upper lightly doped layer **22b** (with a thickness of about 1 µm), while the lower part thereof becomes an n-type lower doped layer **22a** (with a thickness of about 4 µm) as in the structure shown in FIG. **1A**. In this case, a peak of the concentration of N atoms introduced is located at the bottom of the epitaxial layer **22** (i.e., at the surface of the SiC substrate **21**). The concentration of the n-type dopant (e.g., nitrogen) in the n⁺-type SiC substrate **21** is about 1×10¹⁸ atoms · cm⁻³, while the average N concentration in the entire doped layer **22** is about 1×10¹⁶ atoms · cm⁻³.

Next, in the process step shown in FIG. **6B,** the SiC substrate **21** is placed in the chamber of an annealing furnace with a structure such as that shown in FIG. **2**. Then, the implant-induced damage done on the doped layer **22** is repaired and the upper part **22b** of the doped layer **22** is etched away under the conditions specified for the first embodiment. In this process step, the flow rate of hydrogen gas is set to 2 l/min, the pressure inside the chamber is fixed at the atmospheric pressure and the substrate is heated to and kept at 1600°C. This anneal-etch process is performed for about 30 minutes under these conditions, thereby removing the upper doped layer 22b almost completely.

Subsequently, in the process step shown in FIG. **6C**, a nickel (Ni) film to be an electrode is deposited on the backside of the n⁺-type SiC substrate **21** using a vacuum evaporation apparatus. Then, the substrate is annealed at 1000°C for three minutes to form a backside electrode **23** that makes an ohmic contact with the SiC substrate **21**.

Thereafter, a silicon dioxide film is deposited on the substrate and partially removed to form a girdling **24**. Then, a surface electrode **25** of gold (Au) is formed thereon as a Schottky electrode to fill in the opening of the girdling **24**.

According to the second embodiment, the upper part **22b** of the doped layer **22** is etched away. In this case, the process can be controlled in such a manner that the bottom of the surface electrode **25** is in contact with the part of the doped layer **22** with the highest dopant concentration as shown in FIG. **1A.** That is to say, the dopant (N in this case) concentration at the surface of the lower doped layer **22a,** which remains after the upper part **22b** has been removed, can be controlled to a concentration required for making a Schottky contact. In addition, the upper part **22b,** which has been seriously damaged (or has a lot of defects) as a result of the ion implantation processes, is etched away. Accordingly, the region located right under the surface electrode **25** as a Schottky electrode has good enough crystallinity. Consequently, unlike a known Schottky diode on an SiC substrate, whose breakdown voltage decreases probably because a current flows due to the existence of defects under the surface electrode, the diode can maintain a high breakdown voltage and can exhibit excellent characteristics as a power diode.

### EMBODIMENT 3

Next, a third embodiment of the present invention will be described. This embodiment relates to a method for forming a MISFET by utilizing the concurrent anneal-etch process of the first embodiment.

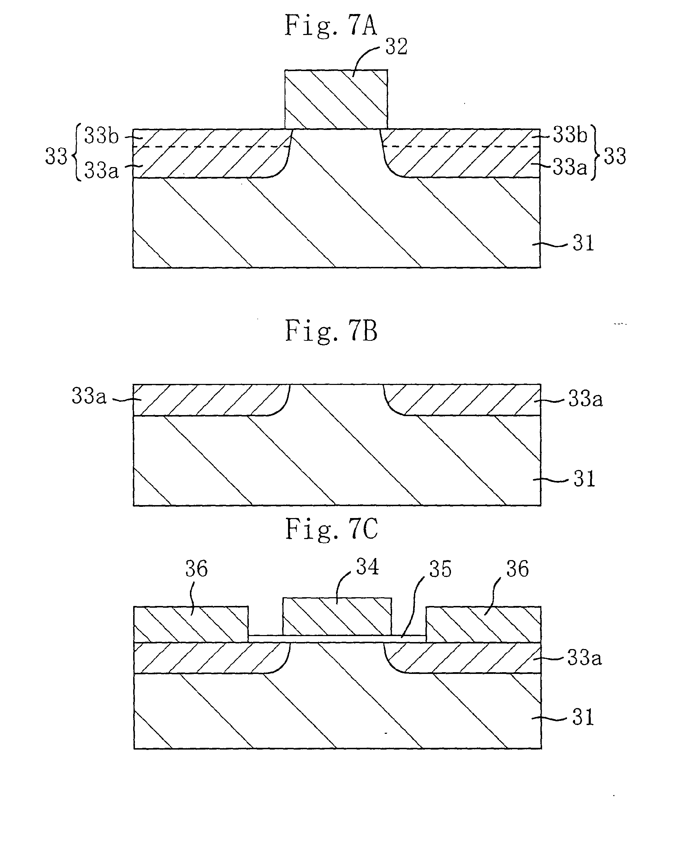

FIGS. **7A** through **7C** are cross-sectional views illustrating respective process steps for forming a MISFET according to the third embodiment.

First, in the process step shown in FIG. **7A**, an implant mask **32** of tungsten, for example, is defined on an n-type SiC substrate **31**, which may be a 6H-SiC substrate with a (0001) off-axis plane as its principal surface. This mask covers part of the substrate **31** to be a channel region for a MISFET but does not cover other parts thereof to be source/drain regions. Then, Al ions are implanted from over the mask **32** into the SiC substrate **31** a number of times as in the embodiment illustrated in FIGS. **1A** through **1C,** thereby forming a p-type source/drain doped layer **33.** In this case, the upper part of the doped layer **33** becomes an upper lightly doped layer 33b (with a thickness of about 1*µ*m), while the lower part thereof becomes a p-type lower doped layer **33a** (with a thickness of about 4 *µ*m) as in the structure shown in FIG. **1A.**

Next, in the process step shown in FIG. **7B,** the SiC substrate **31** is placed in the chamber of an annealing furnace with a structure such as that shown in FIG. **2**. Then, the implant-induced damage done on the source/drain doped layer **33** is repaired and the upper part **33b** of the doped layer **33** is etched away under the conditions specified for the first embodiment. In this process step, the flow rate of hydrogen gas is set to 2 l/min, the pressure inside the chamber is fixed at the atmospheric pressure and the substrate is heated to and kept at 1600°C. This anneal-etch process is performed for about 30 minutes under these conditions, thereby removing the upper doped layer **33b** and another part of the SiC substrate **31** located between the right- and left-hand-side parts of the upper doped layer **33b**. As a result, the lower doped layer **33a** will be left as source/drain regions for a MISFET.

Then, in the process step shown in FIG. **7C**, a thermal oxide film **35** to be a gate insulating film is formed on the substrate, and then a gate electrode **34** is formed out of a nickel film so as to cover the channel region. Subsequently, parts of the thermal oxide film **35,** now covering the source/drain regions, are removed. Instead, source/drain electrodes **36,** making an ohmic contact with the lower doped layer **33a** as source/drain regions, are formed out of a nickel film to fill in the openings. In this process step, the substrate is annealed at 1000°C for three minutes to make the ohmic contact.

In the MISFET formed by the method of the third embodiment, the lower doped layer **33a,** or source/drain regions, is not self-aligned with the gate electrode **34**. However, a gate electrode provided for a MISFET as a power electronic device normally has a gate length of 1 *µ*m or more. Accordingly, even if the source/drain regions and gate electrode are misaligned with each other by about 0.15 *µ*m due to the mask-to-mask placement error, the operation of the resultant MISFET is hardly affected.

If a p-type SiC substrate is used instead of the n-type SiC substrate **31** and nitrogen or phosphorus ions are implanted thereto after an implant mask has been defined thereon, then an n-channel MISFET can be formed.

At least those parts of the SiC substrate **31**, in which the source/drain doped layer **33** is formed in the illustrated embodiment, may be included in an epitaxial layer on the SiC substrate.

Although not described herein, the inventive etching method is naturally applicable to forming a MESFET or a highvoltage device like an ACCUFET (accumulation mode FET) as can be easily understood from the description of the second and third embodiments.

## Claims

1. A method for fabricating a semiconductor device on a substrate, which includes a semiconductor layer containing at least silicon and carbon, so that an active region of the device is defined in the semiconductor layer, the method comprising the steps of:
a) implanting ions of a dopant into the semiconductor layer; and
b) placing the substrate in a chamber and removing part of the semiconductor layer to a predetermined depth with the substrate heated at least to a temperature at which the dopant is activated, the depth being measured from the surface of the semiconductor layer, the step b) being performed after the step a) has been performed.

2. The method of Claim 1, wherein in the step b), said part of the semiconductor layer is removed so that the dopant has a predetermined concentration at the surface of the other remaining part of the semiconductor layer.

3. The method of Claim 1, wherein in the step b), an etching gas, which has a property of etching the semiconductor layer, is introduced into the chamber to etch away said part of the semiconductor layer.

4. The method of Claim 1, wherein the semiconductor layer is made of silicon carbide, and
wherein in the step b), said part of the semiconductor layer is etched away using a gas that contains at least one element selected from the group consisting of hydrogen and the halogen elements.

5. The method of Claim 4, wherein in the step b), the substrate is heated to a temperature between 1300°C and 2300°C.

6. The method of Claim 4, wherein in the step b), the etching gas is supplied at a flow rate between 0.001 l/min and 10 l/min.
